(19) Europäisches Patentamt
European Patent Office
Office européen des brevets

(11) **EP 1 394 930 A1**

(12) **DEMANDE DE BREVET EUROPEEN**

(43) Date de publication:
**03.03.2004 Bulletin 2004/10**

(51) Int Cl.$^7$: **H03B 28/00**, H03L 7/099, H03B 5/24

(21) Numéro de dépôt: **03368084.4**

(22) Date de dépôt: **29.08.2003**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(30) Priorité: **30.08.2002 FR 0210747**

(71) Demandeur: **STMicroelectronics S.A.**
**92120 Montrouge (FR)**

(72) Inventeur: **Grillo, Lionel**
**38240 Meylan (FR)**

(74) Mandataire: **Schuffenecker, Thierry**
**97, chemin de Cassiopée,**
**Domaine de l'étoile**
**06610 La Gaude (FR)**

(54) **Générateur de fréquence et d'onde sinusoidale et convertisseur de signaux périodiques l'utilisant**

(57) Un générateur de fréquence sinusoïdale comportant un circuit oscillant commandé par une tension de commande ($V_{filt}$) caractérisé en ce que ledit circuit oscillant est un gyrateur (114) constitué de deux amplificateurs de transconductance (201, 202) dont les points de polarisation sont fixés par ladite tension de commande de ($V_{filt}$) afin de régler la fréquence d'oscillation. Le gyrateur peut être facilement intégré dans une boucle d'asservissement de phase afin de réaliser un convertisseur de fréquence carrée en fréquence sinusoïdale.

Fig.1

## Description

## Domaine technique de l'invention

La présente invention concerne les circuits générateurs de fréquences sinusoïdales et notamment un circuit convertisseur générant un signal sinusoïdal.

## Etat de la technique

L'état de la technique comporte d'innombrables circuits générateurs de signaux sinusoïdaux.

En général pour générer un signal sinusoïdal, on part fréquemment d'un signal périodique carré, généré par un synthétiseur numérique de fréquence, que l'on filtre au moyen d'un ou plusieurs filtres passe-bandes afin d'en extraire l'harmonique fondamentale. L'avantage d'un tel procédé réside dans le fait que l'on peut caler la fréquence du signal sinusoïdal ainsi généré sur celle du signal carré et que l'on peut bénéficier ainsi de la précision offerte par les synthétiseurs numériques. En revanche, le taux important d'harmoniques impaires que contient le signal périodique carré rend particulièrement malaisée l'opération de filtrage et il faut alors multiplier les filtres et accroître leur complexité pour espérer arriver à un taux de distorsion faible dans la sinusoïde générée.

Le brevet US 5,852,385 décrit un oscillateur commandé par une tension qui est basé sur des amplificateurs à transconductance.

Le brevet US 5,635,879 décrit une boucle de phase utilisant un oscillateur basé numérique basé sur un ensemble de deux amplificateurs à transconductance.

Le brevet EP 0 455 298 est un autre exemple d'oscillateur commandable basé sur des amplificateurs à transconductance.

Le brevet US 4,760,353 décrit un oscillateur basée sur une structure de gyrateur.

Dans bien des circuits il est pourtant particulièrement souhaitable de pouvoir bénéficier de la précision offerte par un synthétiseur numérique de fréquence tout en préservant la pureté du signal sinusoïdal généré. Le problème technique à résoudre consiste alors en la réalisation d'un convertisseur de signal périodique carré-sinusoïdal qui soit simple à mettre en oeuvre - et qui offre une linéarité suffisante pour des applications sophistiquées et notamment les tuners de démodulateurs de fréquence. De surcroît il serait souhaitable que le circuit puisse être aisément intégré dans un produit semi-conducteur.

## Exposé de l'invention

La présente invention a pour but de proposer un circuit générateur d'un signal sinusoïdal simple et peu coûteux à mettre en oeuvre.

Un autre but de la présente invention consiste à proposer un convertisseur de fréquence carré facile à intégrer dans un produit semi-conducteur et qui permette de générer un signal sinusoïdal de grande qualité dans une large gamme de fréquences.

L'invention réalise ces buts au moyen d'un générateur de fréquence sinusoïdale comportant

- un circuit synthétiseur numérique de fréquence générant un signal à fréquence variable ;
- un comparateur de phase comportant une première et seconde entrée recevant respectivement le signal en sortie dudit synthétiseur numérique et un signal de retour ;
- un circuit de pompe de charge recevant le signal de sortie dudit comparateur de phase et générant une tension de commande ($V_{filt}$) ;
- un circuit oscillant comprenant un premier et second amplificateurs à transconductance, ledit circuit oscillant étant monté en gyrateur et caractérisé en ce que chacun desdits premier et second amplificateur à transconductance comporte une structure différentielle dotée d'une charge active ayant dont les points de polarisation sont fixés par ladite tension de commande ($V_{filt}$) afin de régler la fréquence d'oscillation et réglé de manière à générer un signal de forme sinusoïdale ;

et en ce qu'il comporte un élément recevant ledit signal de forme sinusoïdale et générant un signal de retour de forme carrée

On réalise de cette manière un générateur d'une forme d'onde sinusoïdale particulièrement simple à mettre en oeuvre et qui tire avantage du fort coefficient de qualité du gyrateur.

Préférentiellement, chacun des amplificateurs de transconductance comporte :

- un étage différentiel composé d'un premier transistor et d'un second transistor dont les grilles constituant l'entrée dudit étage ;
- un troisième et quatrième transistor constituant respectivement des charges actives pour les premier et second transistors;
- un cinquième transistor monté en source de courant de l'étage différentiel.

On commande le courant de polarisation des troisième, quatrième et cinquième transistors par la tension de commande ($V_{filt}$) .

Dans un mode de réalisation particulier on commande dans chaque amplificateur de transconductance le point de polarisation au moyen d'un sixième transistor dont la source étant connectée à un potentiel de référence ($V_{dd}$) et dont le drain reçoit la tension de commande ($V_{filt}$) . Un septième transistor (307) présente une électrode de source connectée au potentiel de référence ($V_{dd}$) et une grille connectée à la grilles des sixième, troisième et quatrième transistors. Un huitième transistor, dont la source est connectée à la masse, présente ses électrodes de drain et de grille connectées au drain du septième transistor et à la grille du cinquième transistor qui forme la source de courant de l'étage différentiel. Ainsi la tension de commande ($V_{filt}$) peut elle commander le courant dans le sixième transistor, lequel est ensuite recopié dans les charges actives constituées par les troisième et quatrième transistor, ainsi que dans la source de courant formée par le cinquième transistor.

De préférence, on filtre le signal généré par le gyrateur au moyen d'un filtre présentant une structure similaire à celle de chaque des amplificateurs constitutifs du gyrateur, et dont le point de polarisation est également fixé par ladite tension de commande ($V_{filt}$).

On arrive ainsi à générer une sinusoïde présentant une distorsion harmonique totale (THD) supérieure à 35 dB et ce dans une large gamme de fréquences, par exemple entre 70 et 130 Mhz.

Des filtres supplémentaires peuvent être prévus en aval du générateur, de manière à permettre, autant que de besoin, de filtrer la sinusoïde générée.

Le circuit est particulièrement adapté à la réalisation de tuner de fréquences pour un récepteur satellite ou câble.

L'invention permet également la réalisation d'un convertisseur d'un signal périodique carré en signal sinusoïdal, et ce au moyen d'un gyrateur monté en oscillateur et dont le point de polarisation est fixée par une tension de commande $V_{filt}$, laquelle est générée par une boucle d'asservissement de phase.

**Description des dessins**

D'autres caractéristiques, but et avantages de l'invention apparaîtront à la lecture de la description et des dessins ci-après, donnés uniquement à titre d'exemples non limitatifs. Sur les dessins annexés :

La figure 1 illustre un mode de réalisation préféré du convertisseur numérique de signaux.

La figure 2 représente le schéma de principe du gyrateur.

La figure 3 illustre un mode de réalisation d'un amplificateur de transconductance selon l'invention réalisé au moyen de transistors de type MOS.

La figure 4 illustre un mode de réalisation du premier filtre permettant le filtrage des signaux générés par le gyrateur 114.

**Description d'un mode de réalisation préféré**

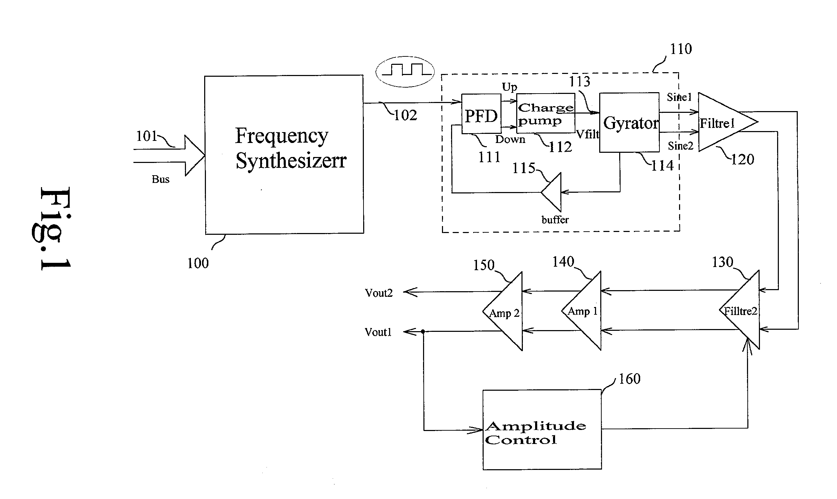

La figure 1 illustre un mode de réalisation préféré de l'invention. Un synthétiseur numérique 100 génère un signal périodique carré 102 à une fréquence qui est déterminée en fonction de l'information présentée à un bus d'entrée 101. Un tel synthétiseur numérique est bien connu d'un homme du métier et on ne le décrira pas plus avant. Il est notamment disponible dans le commerce sous la forme d'un circuit intégré spécialisé. D'une manière générale, qu'il s'agisse d'un circuit du commerce ou d'un circuit spécialement adapté pour une application spécifique, on choisira un synthétiseur qui génère un signal carré dans la bande de fréquence souhaitée. Dans le mode de réalisation préféré de l'invention, le circuit convertisseur sert à la réalisation d'un tuner de réception câble qui sera directement intégré dans un produit semi-conducteur et l'on utilise alors un synthétiseur de fréquence permettant de générer un signal carré pour une gamme de fréquences variant de 1 Mhz à 216 Mhz avec un pas de 432 Hz. Naturellement, ces valeurs ne sont qu'indicatives et l'on aura compris que l'homme du métier pourra facilement adapter le circuit de l'invention à d'autres gammes de fréquences et d'autres réalisations possibles.

Il est à noter également que le synthétiseur de fréquence est optionnel et celui-ci peut être simplement remplacé par un générateur de fréquence carré fixe si l'on ne souhaite pas faire varier la fréquence.

Le signal périodique carré 102 est ensuite transmis à un convertisseur 110 qui va considérablement mettre en forme le signal périodique 102. A cet effet, le convertisseur 110 incorpore un circuit gyrateur 114, lequel est monté en convertisseur tension-fréquence, c'est à dire en un circuit oscillant dont la fréquence est commandée par une tension de polarisation $V_{filt}$ 113. De préférence, le gyrateur 114 produit deux composantes différentielles SINE1 et SINE2, dont l'une d'entre elles est réinjectée dans une boucle de phase permettant un asservissement sur la fréquence du signal périodique 102. On ré-injecte une des deux composantes (par exemple SINE1) à l'entrée d'un élément buffer 115 qui produit alors en sortie un signal périodique carré que l'on peut comparer au signal d'entrée 102 au moyen d'un comparateur de phase 111 (ou Phase Frequency Detector). En sortie, le comparateur de phase 111 génère en fonction du sens de l'écart entre la fréquence en sortie du buffer 115 et la fréquence du signal périodique 102 deux signaux de commande, respectivement un signal de commande UP et un signal de commande DOWN.

Les signaux de commande UP et DOWN servent à commander une pompe de charge 112 utilisée pour la génération d'une tension $V_{filt}$ servant à la commande du circuit gyrateur 114.

L'ensemble constitué par le circuit gyrateur 114, le buffer 115, le circuit PFD 111 et la pompe de charge 112 réalise ainsi un générateur sinusoïdal dont la fréquence est asservie sur celle du signal d'entrée 102.

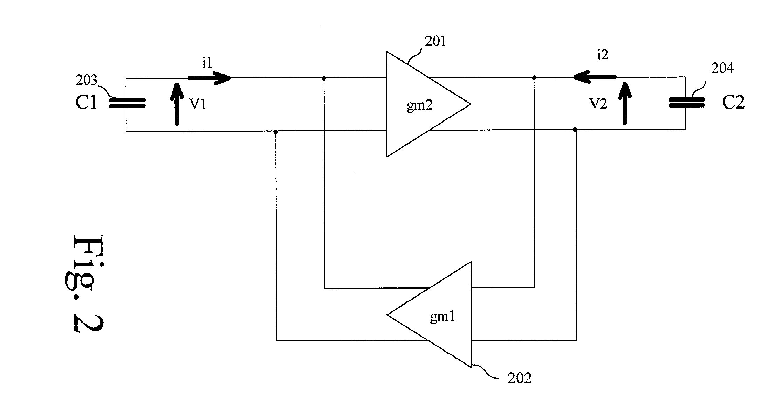

La figure 2 rappelle la structure d'un circuit gyrateur, que l'on réalise au moyen d'un premier amplificateur de transconductance 201 (présentant un coefficient gm2) et d'un second amplificateur de transconductance 202 (présentant un coefficient gm1). Chacun des deux amplificateurs de transconductance 201 et 202 comporte deux entrées différentielles que l'on connecte à la sortie de l'autre amplificateur et l'ensemble des deux amplificateurs opérationnels réalise un quadripôle dont on peut écrire les équations caractéristiques :

$$V_1 = - Z_1 \cdot i_1 \text{ et } V_2 = Z_2 \cdot i_2 ,$$

d'une part et

$$I_1 = gm1 \cdot v_2 \text{ et } I_2 = -gm2 \cdot v_1$$

d'autre part

D'où il en résulte que :

$$Z_2 = 1/(gm1 \cdot gm2 \cdot Z_1)$$

On voit donc que l'impédance $Z_2$ vue du côté du port 2 de ce quadripôle particulier est en fonction inverse de l'impédance $Z_1$ connectée sur le port 1. En connectant un condensateur 203 ($C_1$) aux entrées de l'amplificateur de transconductance 201 on peut ainsi simuler une inductance $L = C_1/gm1 \cdot gm2$ et en combinant cette inductance L avec un second condensateur 204 ($C_2$) connecté aux entrées de l'amplificateur 202 on réalise ainsi un circuit oscillant.

On peut ainsi réaliser un circuit oscillant au moyen d'un gyrateur comportant deux amplificateurs de transconductance dont on peut fixer le point de polarisation au moyen de la tension de commande $V_{filt}$ 113 générée par la pompe de charge 112. On fait ainsi varier les paramètres gm1 et gm2 des deux amplificateurs de transconductance et on peut alors commander précisément la fréquence du circuit oscillant réalisé au moyen du gyrateur 114. On obtient ainsi d'une manière particulièrement avantageuse un nouveau circuit oscillant dont on pourra faire varier la fréquence d'oscillation et l'ajuster afin que celle-ci s'asservisse sur la fréquence d'entrée 102, précisément fixée par le synthétiseur de fréquence 100. D'une manière préférentielle on optera pour une valeur de capacité identique pour $C_1$ et $C_2$.

Lorsque l'on intègre le gyrateur 114 dans la boucle de phase réalisée par l'élément buffer 115 et le circuit de détection de phase 111, on arrive à produire ainsi une composante sinusoïdale de grande qualité, dont la fréquence est asservie sur le signal périodique carré 102 au moyen de l'asservissement à boucle de phase réalisé par l'ensemble 111 et 115. On peut alors régler précisément la fréquence du signal sinusoïdal au moyen du synthétiseur de fréquence 100.

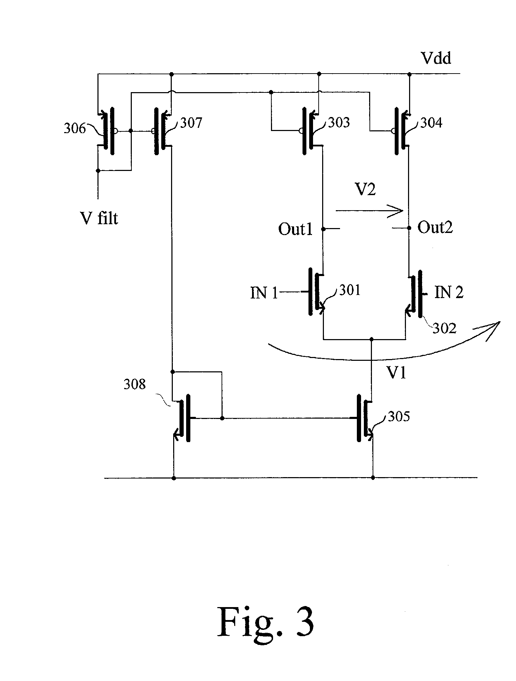

La figure 3 montre un mode de réalisation particulier d'un amplificateur de transconductance permettant de réaliser le gyrateur 114, étant entendu que l'on connectera deux amplificateurs similaires afin de réaliser le quadripôle de la figure 2 en son entier. L'amplificateur de transconductance comporte une paire différentielle composée de transistors de type NMOS 301 et 302 dont les grilles reçoivent les deux entrées IN1 et IN2. La source de chacun des transistors NMOS 301 et 302 est connectée au drain d'un transistor NMOS 305 , lequel sert de source de courant pour la paire différentielle 301-302. Le transistor 305 dispose d'une électrode de source connectée à la masse. Le drain du transistor 301 (resp. 302) est connecté, d'une part, au drain d'un transistor 303 de type PMOS (resp. 304) dont l'électrode de source est connectée à la tension d'alimentation $V_{dd}$ et, d'autre part, à une première sortie OUT1 (resp. seconde sortie OUT2). Les grilles des transistors 303 et 304 sont connectées à la grille d'un transistor PMOS 307, lequel dispose d'une électrode de source connecté à la tension d'alimentation $V_{dd}$ . Le transistor 307 dispose également d'une électrode de drain connectée au drain et à la grille d'un transistor NMOS 308, ainsi qu'à la grille du transistor 305 qui constitue la source de courant de la paire différentielle 301 et 302. L'électrode de source du transistor 308 est connectée à la masse du circuit.

La tension de commande $V_{filt}$ 113 qui est générée en sortie de la pompe de charge 112 (de la figure 1) est présentée au drain d'un transistor de type PMOS 306, dont l'électrode de source est connectée à la tension d'alimentation $V_{dd}$. La grille du transistor 306 est connectée à la grille des transistors 307, 303 et 304. La tension $V_{filt}$ est également connectée à la grille des transistors 306, 307, 303 et 304.

Le fonctionnement de l'amplificateur de transconductance est le suivant. La tension $V_{filt}$ commande le courant qui circule dans le drain du transistor 306 et par conséquent 307 également. Concrètement, lorsque la tension de commande $V_{filt}$ augmente, le transistor 307 devient moins conducteur. Le courant qui le parcourt est recopié, avec des coefficients différents qui sont fonctions de la géométrie particulière des transistors, d'une part, dans les transistors miroirs de courant 303 et 304 et d'autre part dans les transistors 307-308 qui viennent commander la source de courant 305. On dispose ainsi d'un élément de réglage très efficace du point de polarisation de l'amplificateur de transconductance et fixer son paramètre gm.. La connexion existant entre, d'une part, les grilles des transistors 306/307 et, d'autre part, les grilles des transistors 303/304 permet de réaliser une charge active pour l'amplificateur de transconductance formé la paire de transistors 301 et 302 et c'est cette charge active qui assure l'oscillation lorsque ledit amplificateur est combiné avec un second amplificateur de même type (ainsi qu'avec les capacités $C_1$ et $C_2$ ) afin de réaliser le quadripôle illustré en figure 2. Par souci de clarté, on a représenté sur la figure 3 la correspondance entre d'une part, la tension $V_1$ et les potentiels de IN1 et IN2 et, d'autre part la tension $V_2$ et les potentiels de OUT1 et OUT2. On utilise les deux sorties différentielles de l'un des deux amplificateurs de transconductance afin de générer les composantes SINE1 et SINE2 que l'on voit sur la figure 1.

D'une manière avantageuse, l'élément buffer 115 de la figure 1 est réalisé au moyen d'une cascade d'éléments NMOS et PMOS dont les grilles sont connectées ensemble - de manière à régénérer un signal carré nécessaire à la comparaison avec le signal périodique en entrée de 102 .

En revenant à nouveau à la figure 1, on va à présent décrire la manière d'améliorer grandement la linéarité des sinusoïdes SINE1 et SINE2 au moyen des traitements décrits ci-après.

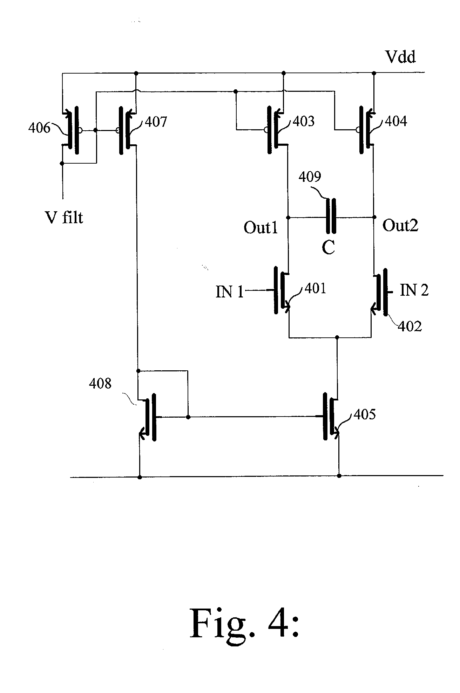

On présente d'abord les deux signaux SINE1 et SINE2 à l'entrée d'un filtre passe-bas 120 dont on ajuste la fréquence de coupure au moyen de la même tension de commande $V_{filt}$ que celle qui sert à commander chacun des deux amplificateurs constitutifs du gyrateur 114. A cet effet, comme on le voit sur la figure 4, on réalise le filtre 120 au moyen d'un troisième amplificateur de transconductance qui présente une structure similaire à celle de chacun des deux amplificateurs qui composent le gyrateur 114. Les transistors 401 à 408 correspondent aux transistors 301-308 de la figure 3. Plus précisément, une paire différentielle est constituée de deux transistors 401 et 402 dont les grilles reçoivent les deux entrées IN1 et IN2. Chaque transistor 401 (resp. 402) dispose d'une source connectée à un transistor 405 source de courant et une électrode de drain connectée à Vdd via un transistor 403 (resp. 404). Les grilles des transistors 403 et 404 sont connectées à la grille d'un transistor 407 dont la source est connectée à $V_{dd}$ et dont le drain est connecté à la grille et au drain d'un transistor 408 et également à la grille du transistor 405. Le transistor 408 présente une électrode de source qui est connectée à la masse du circuit. La tension Vfilt est également connectée à la grille des transistors 406, 407, 403 et 404.

Comme pour chacun des deux amplificateurs de transconductance qui composent le gyrateur 114, la tension de commande $V_{filt}$ est présentée au drain d'un transistor 406 dont la source est connectée à la tension d'alimentation Vdd. La grille du transistor 406 est connectée à la grille du transistor 407 ainsi qu'à la grille des transistors 403 et 404 . En sortie de la paire différentielle 401-402 on dispose au moins un condensateur 409 (C) pour réaliser un filtrage passe-bas du filtre 120. D'une manière particulièrement avantageuse, on vient commander les points de polarisation de ce troisième amplificateur de transconductance, et notamment les courants des miroirs des courants 403 et 404 au moyen de la tension de commande $V_{filt}$ qui sert également à fixer la fréquence d'oscillation du gyrateur. On ajuste de cette manière le paramètre gm de la paire différentielle 401-402 et par conséquent la fréquence de coupure du filtre 120 afin que celle-ci corresponde parfaitement à la fréquence d'oscillation du gyrateur 114. Ainsi on peut au moyen d'un unique réglage - à savoir par l'intermédiaire de la tension de commande $V_{filt}$ générée par la pompe de charge 112 - commander simultanément la fréquence d'oscillation du gyrateur et le filtrage opéré par le filtre 120.

Optionnellement, on peut encore réserver un traitement supplémentaire sur les composantes SINE1 et SINE2 générées et filtrée par le filtre 120. A cet effet on réalise une amplification supplémentaire avec un ajustement du gain de cette amplification pour amener l'amplitude des sinusoïdes à une valeur souhaitée. En se référant à nouveau à la figure 1, on voit que l'on peut employer, en cascade avec le premier filtre 120, un second filtre passe-bande 130 suivis de deux amplificateurs à gain fixe, respectivement 140 (Amp1) et 150 (Amp2). Un circuit de détection d'amplitude 160 permet de mesurer l'amplitude du signal sur l'une des deux composantes sinusoïdales (par exemple $V_{out2}$) en sortie de l'amplificateur 150, et ajuste l'effet de filtre 130 de manière à normaliser l'amplitude de sortie de cette sinusoïde. Préférentiellement, la commande de l'amplitude se fait en venant fixer, une fois encore, le courant de polarisation des transistors constitutifs du second filtre 130 au moyen d'une tension de commande générée par le bloc 160. Si l'on fixe suffisamment bas la fréquence de coupure du filtre de manière à la situer en deçà de la gamme de fréquence considérée, on voit que l'on peut réaliser un filtrage supplémentaire assortie d'un gain variable, lequel gain est simplement ajusté au moyen d'une tension de commande fournie par le circuit de détection d'amplitude 160. Il n'est alors pas nécessaire de prévoir des amplificateurs 140 et 150 à gain variable pour fournir en sortie des signaux $V_{out\,1}$ et $V_{out2}$ d'amplitude normalisée et qui, de surcroît, présentent une linéarité remarquable, avec un taux de distorsion qui atteint facilement 35 dB.

La paire différentielle 301 et 302 est basée sur des transistors de type NMOS. Il est clair que l'homme du métier pourra adapter la description à la constitution d'une paire de transistors de type PMOS en inversant la polarité de chaque transistor.

Le circuit de l'invention qui vient d'être décrit est parfaitement adapté à la réalisation d'un tuner de réception de fréquences fonctionnant dans une large gamme de fréquences, et que l'on peut aisément intégrer dans un produit semi-conducteur.

### Revendications

1. Générateur de fréquence sinusoïdale variable comportant :

   - un circuit synthétiseur numérique de fréquence (100) générant un signal à fréquence variable ;
   - un comparateur de phase (111) comportant une première et seconde entrée recevant respectivement le signal en sortie dudit synthétiseur numérique et un signal de retour ;
   - un circuit de pompe de charge (112) recevant le signal de sortie dudit comparateur de phase et générant une tension de commande ($V_{filt}$) ;

- un circuit oscillant comprenant un premier et second amplificateurs à transconductance (201, 202) monté en gyrateur ;

**caractérisé en ce que** chacun desdits premier et second amplificateur à transconductance (201, 202) comporte une structure différentielle dotée d'une charge active ayant dont les points de polarisation sont fixés par ladite tension de commande ($V_{filt}$) afin de régler la fréquence d'oscillation et réglé de manière à générer un signal de forme sinusoïdale ;

et **en ce qu'**il comporte un élément recevant ledit signal de forme sinusoïdale et générant un signal de retour de forme carrée

2. Générateur selon la revendication 1 **caractérisé en ce que** lesdits premier et second amplificateurs de transconductance (201, 202) comportent :

- un étage différentiel composé d'un premier transistor (301) et d'un second transistor (302) présentant chacun une électrode de source, de drain et de grille ; lesdites électrodes de grille constituant l'entrée dudit étage ;
- un troisième et quatrième transistor (303, 304) présentant une électrode de source, de drain et de grille constituant respectivement des charges actives pour lesdits premier et second transistors;
- un cinquième transistor (305) présentant une électrode de source, de drain et de grille, et constituant une source de courant pour lesdits premiers et second transistors ;

le courant de polarisation desdits troisième, quatrième et cinquième transistors étant commandé par ladite tension de commande ($V_{filt}$) .

3. Générateur selon la revendication 2 **caractérisé en ce que** :

- lesdits premier transistor (301) et second transistor (302) présentent leur électrode de source connectée à l'électrode de drain dudit cinquième transistor (305) ;
- l'électrode de source dudit cinquième transistor (305) est connecté à un premier potentiel de référence ;
- l'électrode de drain dudit premier transistor (301) est connectée à l'électrode de drain dudit troisième transistor (303) dont l'électrode de source est connectée à un second potentiel de référence ($V_{dd}$) ;
- l'électrode de drain dudit second transistor (302) est connectée à l'électrode de drain dudit quatrième transistor (304) dont l'électrode de source est connectée audit second potentiel de référence ($V_{dd}$),

- l'électrode de grille desdits troisième, quatrième et cinquième transistors est commandée par ladite tension de commande ($V_{filt}$).

4. Générateur selon la revendication 3 **caractérisé en ce que** chaque amplificateur comporte :

- un sixième transistor (306) présentant une électrode de source, de drain et de grille, ladite électrode de source étant connectée audit second potentiel de référence ($V_{dd}$) , ladite électrode de drain recevant ladite tension de commande ($V_{filt}$),
- un septième transistor (307) présentant une électrode de source, de drain et de grille, ladite électrode de source du septième transistor étant connectée audit second potentiel de référence ($V_{dd}$), ladite électrode de grille dudit septième transistor étant connectée aux électrodes de grille desdits sixième, troisième et quatrième transistors, et à ladite tension de commande ( Vfilt) ;
- un huitième transistor (308) présentant une électrode de source, de drain et de grille, ladite électrode de source dudit huitième transistor (308) étant connectée audit premier potentiel de référence, lesdites électrodes de drain et de grille dudit huitième transistor (308) étant toutes deux connectées à l'électrode de drain dudit septième transistor (307) et à l'électrode de grille dudit cinquième transistor (305).

5. Générateur selon la revendication 1 **caractérisé en ce que** qu'il comporte un premier filtre constitué d'un troisième amplificateur de transconductance monté en fitlre et dont le point de polarisation est lui également fixé par ladite tension de commande ($V_{filt}$).

6. Générateur selon la revendication 1 **caractérisé en ce que** ledit troisième amplificateur de transconductance comporte :

- un étage différentiel composé d'un premier transistor (401) et d'un second transistor (402) présentant chacun une électrode de source, de drain et de grille ; lesdites électrodes de grille constituant l'entrée dudit étage ;
- un troisième et quatrième transistor (403, 404) présentant une électrode de source, de drain et de grille constituant respectivement des charges actives pour lesdits premier et second transistors;
- un cinquième transistor (405) présentant une électrode de source, de drain et de grille, et constituant une source de courant pour lesdits premiers et second transistors ;

le courant de polarisation desdits troisième, quatrième et cinquième transistors étant commandé par ladite tension de commande ($V_{filt}$).

**7.** Générateur selon la revendication 6 **caractérisé en ce que** :

- lesdits premier transistor (401 ) et second transistor (402) présentent leur électrode de source connectée à l'électrode de drain dudit cinquième transistor (405) ;
- l'électrode de source dudit cinquième transistor (405) est connecté à un premier potentiel de référence ;
- l'électrode de drain dudit premier transistor (401) est connectée à l'électrode de drain dudit troisième transistor (403) dont l'électrode de source est connectée à un second potentiel de référence ($V_{dd}$) ;
- l'électrode de drain dudit second transistor (402) est connectée à l'électrode de drain dudit quatrième transistor (404) dont l'électrode de source est connectée audit second potentiel de référence ($V_{dd}$),
- l'électrode de grille desdits troisième, quatrième et cinquième transistors est commandée par ladite tension de commande ($V_{filt}$).

Le troisième amplificateur comportant en outre :

- un sixième transistor (406) présentant une électrode de source, de drain et de grille, ladite électrode de source étant connectée audit second potentiel de référence ($V_{dd}$) , ladite électrode de drain recevant ladite tension de commande ($V_{filt}$),
- un septième transistor (407) présentant une électrode de source, de drain et de grille, ladite électrode de source du septième transistor étant connectée audit second potentiel de référence ($V_{dd}$), ladite électrode de grille dudit septième transistor étant connectée aux électrodes de grille desdits sixième, troisième et quatrième transistors, et à ladite tension de commande (Vfilt );
- un huitième transistor (408) présentant une électrode de source, de drain et de grille, ladite électrode de source dudit huitième transistor (408) étant connectée audit premier potentiel de référence, lesdites électrodes de drain et de grille dudit huitième transistor (408) étant toutes deux connectées à l'électrode de drain dudit septième transistor (407) et à l'électrode de grille dudit cinquième transistor (405).

**8.** Dispositif selon la revendication 5 **caractérisé en ce qu'**il comporte un second filtre passe-bas fonctionnant au delà de sa fréquence de coupure, ledit second filtre comportant un amplificateur dont le point de polarisation est commandé par un potentiel commandé par un circuit de détection d'amplitude afin de pouvoir régler le gain de l'amplificateur.

**9.** Convertisseur de signal périodique carré en signal sinusoïdal comportant :

- un comparateur de phase (111) comportant une première et seconde entrée recevant respectivement le signal périodique carré à convertir et un signal de retour ;
- un circuit de pompe de charge (112) recevant le signal de sortie dudit comparateur de phase et générant une tension de commande ($V_{filt}$) ;
- un circuit oscillant comprenant un premier et second amplificateurs à transconductance (201, 202) monté en gyrateur ;

**caractérisé en ce que** chacun desdits premier et second amplificateur à transconductance (201, 202) comporte une structure différentielle dotée d'une charge active ayant dont les points de polarisation sont fixés par ladite tension de commande ($V_{filt}$) afin de régler la fréquence d'oscillation et réglé de manière à générer un signal de forme sinusoidale ;

- un élément buffer recevant ledit signal de forme sinusoidal et générant un signal de retour de forme carré.

**10.** Convertisseur selon la revendication 9 **caractérisé en ce que** la boucle d'asservissement comporte des transistors MOS montés en buffer de manière à générer un signal périodique carré à partir des sorties analogiques.

Fig.1

Fig. 2

Fig. 3

Vdd

406  407  403  404

409

V filt

Out1  C  Out2

IN 1  401  IN 2

402

408  405

# Fig. 4:

**Office européen des brevets**

# RAPPORT DE RECHERCHE EUROPEENNE

Numéro de la demande

EP 03 36 8084

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 757 239 A (GILMORE ROBERT P) 26 mai 1998 (1998-05-26) * abrégé; figure 4 * --- | 1,9 | H03B28/00 H03L7/099 H03B5/24 |
| D,A | US 5 852 385 A (IZUMIKAWA MASANORI) 22 décembre 1998 (1998-12-22) * figures 10A,14 * --- | 1-4 | |
| D,A | US 5 635 879 A (SUTARDJA PANTAS ET AL) 3 juin 1997 (1997-06-03) * figures 1,9 * --- | 1,9 | |
| D,A | EP 0 455 298 A (PHILIPS NV) 6 novembre 1991 (1991-11-06) * figure 2 * --- | 1,9 | |
| D,A | US 4 760 353 A (PERKINS GEOFFREY W) 26 juillet 1988 (1988-07-26) * colonne 2, ligne 1 - ligne 5; figure 1 * --- | 1,9 | |
| A | EP 0 803 985 A (HARRIS CORP) 29 octobre 1997 (1997-10-29) * colonne 4, ligne 23 - colonne 5, ligne 17; figure 2 * --- | 5-7 | DOMAINES TECHNIQUES RECHERCHES (Int.Cl.7) H03B H03L |
| A | US 2001/021230 A1 (MYERS BRENT A ET AL) 13 septembre 2001 (2001-09-13) * abrégé; figure 4 * --- | 5 | |
| A | WU J-T ET AL: "TP 5.2: A 2V 100MHZ CMOS VECTOR MODULATOR" IEEE INTERNATIONAL SOLID STATE CIRCUITS CONFERENCE, IEEE INC. NEW YORK, US, vol. 40, 1 février 1997 (1997-02-01), pages 80-81,434, XP000753022 ISSN: 0193-6530 * page 80, colonne de gauche, alinéa 2 - ligne 11-13; figure 1 * --- -/-- | 8 | |

Le présent rapport a été établi pour toutes les revendications

| Lieu de la recherche | Date d'achèvement de la recherche | Examinateur |
|---|---|---|
| LA HAYE | 14 novembre 2003 | Peeters, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

# RAPPORT DE RECHERCHE EUROPEENNE

Numéro de la demande

EP 03 36 8084

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 936 445 A (BABANEZHAD JOSEPH N ET AL) 10 août 1999 (1999-08-10) * colonne 2, ligne 11 - ligne 16; figure 2 * ----- | 10 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| LA HAYE | 14 novembre 2003 | Peeters, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**        EP 03 36 8084

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-11-2003

| Document brevet cité au rapport de recherche | | Date de publication | Membre(s) de la famille de brevet(s) | | Date de publication |
|---|---|---|---|---|---|
| US 5757239 | A | 26-05-1998 | AT | 219612 T | 15-07-2002 |
| | | | AU | 711590 B2 | 14-10-1999 |
| | | | AU | 5298596 A | 02-10-1996 |
| | | | BR | 9607869 A | 14-07-1998 |
| | | | CA | 2215376 A1 | 19-09-1996 |
| | | | CN | 1178613 A ,B | 08-04-1998 |
| | | | DE | 69621919 D1 | 25-07-2002 |
| | | | DE | 69621919 T2 | 13-02-2003 |
| | | | DK | 815648 T3 | 15-07-2002 |
| | | | EP | 0815648 A1 | 07-01-1998 |
| | | | ES | 2179186 T3 | 16-01-2003 |
| | | | FI | 973654 A | 14-11-1997 |
| | | | HK | 1007916 A3 | 30-04-1999 |
| | | | HK | 1007916 A1 | 04-04-2003 |
| | | | PT | 815648 T | 30-09-2002 |
| | | | RU | 2176431 C2 | 27-11-2001 |
| | | | WO | 9628890 A1 | 19-09-1996 |
| US 5852385 | A | 22-12-1998 | JP | 3149797 B2 | 26-03-2001 |
| | | | JP | 10093340 A | 10-04-1998 |
| US 5635879 | A | 03-06-1997 | US | 5576647 A | 19-11-1996 |
| | | | WO | 9701216 A1 | 09-01-1997 |
| | | | US | 5686867 A | 11-11-1997 |
| EP 0455298 | A | 06-11-1991 | DE | 69102813 D1 | 18-08-1994 |
| | | | DE | 69102813 T2 | 02-02-1995 |
| | | | EP | 0455298 A1 | 06-11-1991 |
| | | | HK | 40996 A | 15-03-1996 |
| | | | JP | 4348614 A | 03-12-1992 |
| | | | KR | 185406 B1 | 15-04-1999 |
| | | | US | 5117205 A | 26-05-1992 |
| US 4760353 | A | 26-07-1988 | JP | 1212105 A | 25-08-1989 |
| | | | JP | 2800213 B2 | 21-09-1998 |
| | | | KR | 129039 B1 | 01-10-1998 |
| EP 0803985 | A | 29-10-1997 | US | 5736903 A | 07-04-1998 |
| | | | EP | 0803985 A2 | 29-10-1997 |
| US 2001021230 | A1 | 13-09-2001 | US | 6233293 B1 | 15-05-2001 |
| | | | US | 5953379 A | 14-09-1999 |
| | | | EP | 0792010 A1 | 27-08-1997 |
| US 5936445 | A | 10-08-1999 | AUCUN | | |

EPO FORM P0460

Pour tout renseignement concernant cette annexe : voir Journal Officiel de l'Office européen des brevets, No.12/82